# EUROPEAN PATENT APPLICATION

(11) **EP 4 687 259 A1**
(43) Date of publication of application: **04.02.2026**
(21) Application number: 25188111.6
(22) Date of filing: 08.07.2025
(51) Int. Cl.: H02J 7/00, H01M 10/44, G01R 31/36, H01M 10/48

(54) **SECONDARY BATTERY CHARGING AND DISCHARGING DEVICE**

(30) Priority: 29.07.2024 KR 20240100248
(71) Applicant: SAMSUNG SDI CO., LTD., Yongin-si, Gyeonggi-do 17084 (KR); TM Plaza, Ulsan 44956 (KR)
(72) Inventor: SEO, Sang-Chul, Yongin-si, Gyeonggi-do 17084 (KR); SONG, Tae Yong, Yongin-si, Gyeonggi-do 17084 (KR); LEE, Jaedeuk, Yongin-si, Gyeonggi-do 17084 (KR); HEO, Hyungu, Yongin-si, Gyeonggi-do 17084 (KR); CHO, Byoung Chul, Yongin-si, Gyeonggi-do 17084 (KR); PYO, Young-Hak, Yongin-si, Gyeonggi-do 17084 (KR); BAEK, Seung Hyeok, Yongin-si, Gyeonggi-do 17084 (KR); JUNG, Yonggyu, Ulju-gun, Ulsan 44956 (KR); PARK, Myongkon, Ulju-gun, Ulsan 44956 (KR)
(74) Representative: Gulde & Partner

(57) **Abstract**

A secondary battery charging and discharging device includes: a first measurement part (100) including: a first base portion (110); a first current probe (120) joined to the first base portion (110), and to contact a first terminal (11) of a secondary battery (10); and a temperature probe (130) joined to the first base portion (110), spaced from the first current probe (120) at an interval, and to measure a temperature of the secondary battery (10); and a second measurement part (200) facing the first measurement part (100) with the secondary battery (10) therebetween, and including: a second base portion (210); and a second current probe (220) joined to the second base portion (210), and to contact a second terminal (12) of the secondary battery (10). The first current probe (120) and the second current probe (220) are adapted to charge the secondary battery (10).

## Description

### BACKGROUND

### 1. Field

Aspects of embodiments of the present disclosure relate to a secondary battery charging and discharging device capable of performing charging and discharging on various models of secondary batteries.

### 2. Description of the Related Art

Unlike primary batteries that are not designed to be (re)charged, secondary (or rechargeable) batteries are batteries that are designed to be discharged and recharged. Low-capacity secondary batteries are used in portable, small electronic devices, such as smart phones, feature phones, notebook computers, digital cameras, and camcorders, while large-capacity secondary batteries are widely used as power sources for driving motors in hybrid vehicles and electric vehicles and for storing power (e.g., home and/or utility scale power storage). A secondary battery generally includes an electrode assembly composed of a positive electrode and a negative electrode, a case accommodating the same, and electrode terminals connected to the electrode assembly. Secondary batteries may exhibit performance as batteries only if the secondary batteries go through the process of charging and discharging after manufacturing, that is, a formation process. A charger/discharger performs the function of providing characteristics of a secondary battery by repeating the charging and discharging process several times so that the first secondary battery assembled during the secondary battery production process may store electric energy. The charger/discharger may include a fixture with a probe pin for applying current required for charging and discharging to a secondary battery, and a tray on which the secondary battery is set.

The charger/discharger loads the secondary battery horizontally on the tray, and charges the battery by bring a charging probe pin into contact with a terminal of the secondary battery. However, secondary batteries that are a target of the charging and discharging may have various sizes and positions of electrode terminals.

The above information disclosed in this background section is for enhancement of understanding of the background of the present disclosure, and therefore, it may contain information that does not constitute related (or prior) art.

### SUMMARY

A charger/discharger may have a structure capable of performing charging and discharging on secondary batteries with various design specifications. Depending on the various terminal positions of the secondary batteries, for example, such as from a top terminal secondary battery to a side terminal secondary battery, the position of the probe pin of the charger/discharger may also be changed.

One or more embodiments of the present disclosure may be directed to a secondary battery charging and discharging device capable of performing charging and discharging, and capable of measuring a voltage and a temperature for secondary batteries having various different design specifications.

One or more embodiments of the present disclosure may be directed to a secondary battery charging and discharging device that may be used for charging and discharging various suitable models of secondary batteries, such as a top terminal secondary battery and a side terminal secondary battery.

One or more embodiments of the present disclosure may be directed to a secondary battery charging and discharging method that uses the secondary battery charging and discharging device.

However, the technical problem to be solved by the present disclosure is not limited to the above problem, and other problems not mentioned herein, and aspects and features of the present disclosure that would address such problems, will be clearly understood by those skilled in the art from the description of the present disclosure below.

According to an aspect of the present disclosure, a secondary battery charging and discharging device includes: a first measurement part including: a first base portion; a first current probe joined to the first base portion, and configured to contact a first terminal of a secondary battery; and a temperature probe joined to the first base portion, spaced from the first current probe at an interval, and configured to measure a temperature of the secondary battery. The first current probe may be provided for electrically contacting the first terminal of the secondary battery. The temperature probe may be provided for measuring a temperature of the secondary battery. The secondary battery charging and discharging device includes: a second measurement part facing the first measurement part with the secondary battery therebetween, and including: a second base portion; and a second current probe joined to the second base portion, and configured to contact a second terminal of the secondary battery. The second current probe may be provided for electrically contacting the second terminal of the secondary battery. Between the first current probe and the second current probe, the device may comprise a receiving volume for receiving at least one secondary battery to be charged or discharged by the device. While charging and/or discharging, the secondary battery may be arranged or placed in the receiving volume. The first current probe and the second current probe are configured to charge or discharge the secondary battery. Hence, due to the providing the two base portions, the first and second current probes can be arranged at different locations, such that different secondary batteries with differently arranged terminals can be charged and/or discharged.

In an embodiment, the first current probe, the second current probe, and the temperature probe may be located within a width of the secondary battery and/or of the receiving volume in a width direction. The width direction may extend along the receiving volume. The width direction may extend along a width of the secondary battery. Perpendicular to the width direction, the terminals of the secondary battery may be spaced apart. Perpendicular to the width direction, the first and second current probes may be spaced apart. An advantage of this embodiment may be that a secondary battery with electrodes on opposite sides can be charged or discharged.

In an embodiment, the secondary battery charging and discharging device may further include a vacuum hopper or vacuum suction cup adjacent to the first measurement part, and located with the width. An advantage of this embodiment may be that gas exiting the secondary battery via the hole during charging or discharging can be lead away or discharged in a controlled manner via the vacuum hopper or vacuum suction cup.

In an embodiment, the vacuum hopper or vacuum suction cup may be configured to contact or may be provided for contacting a hole of the secondary battery adjacent to the first terminal, while the first current probe may be in contact with the first terminal. An advantage of this embodiment may be that gas exiting the secondary battery via the hole during charging or discharging can be lead away or discharged in a controlled manner via the vacuum hopper or vacuum suction cup.

In an embodiment, the secondary battery charging and discharging device may further include a third measurement part adjacent to the first measurement part. The third measurement part may include: a third base portion; and a third current probe joined to the third base portion. The third current probe may be configured to contact the first terminal of the secondary battery or the second terminal of the secondary battery. The third current probe may be located with the width. Along the width direction, the terminals of the secondary battery may be spaced apart. Along the width direction, the first and second current probes may be spaced apart. An advantage of this embodiment may be that a secondary battery with electrodes on the same side can be charged or discharged.

In an embodiment, the secondary battery charging and discharging device may further include: a first driver connected to the first measurement part. The first driver may be configured to move the first measurement part. The device may further include: a second driver connected to the second measurement part. The second driver may be configured to move the second measurement part. The device may further include: a controller electrically connected to the first driver and the second driver. The controller may be configured to drive the first driver and the second driver. An advantage of this embodiment may be that the charging of secondary batteries can be automized at least partly.

In an embodiment, the controller may be configured to control at least one of the first driver or the second driver to adjust a movement distance of the first measurement part or the second measurement part in correspondence with a position of the secondary battery. An advantage of this embodiment may be that the charging of secondary batteries can be automized at least partly while considering the secondary battery, e.g. in case the secondary battery is positioned in the receiving volume.

In an embodiment, the first driver may be configured to move the first measurement part in the width direction, so that the first current probe comes into contact with or releases contact with the first terminal of the secondary battery. The second driver may be configured to move the second measurement part in a length direction of the secondary battery or of the receiving volume, so that the second current probe comes into contact with or releases contact with the second terminal of the secondary battery. The length direction may extend perpendicular to the width direction. An advantage of this embodiment may be that secondary batteries with differently positioned terminals can be automatically connected.

In an embodiment, the secondary battery charging and discharging device may further include a tray. The tray may at least partly be arranged in the receiving volume. The tray may have an open upper portion. The tray may have an accommodation space therein. The tray may be configured to receive the secondary battery in the accommodation space. An advantage of this embodiment may be that the secondary battery can be handled more easily when placed on the tray and/or in the accommodation space.

In an embodiment, the secondary battery charging and discharging device may further include a third driver. The third driver may be connected to the tray. The third driver may be configured to move the tray in the length direction, so that the first terminal of the secondary battery comes into contact with or releases contact with the first current probe. An advantage of this embodiment may be that handling the secondary battery on or in the tray can also connect the first terminal of the secondary battery to the first current probe, which reduces handling time.

In an embodiment, the secondary battery charging and discharging device may further include: a first fixture assembly on which a plurality of first measurement parts including the first measurement part may be located at intervals. The device may further include: a tray assembly having a box shape with an open upper portion. In the tray assembly, a plurality of secondary batteries including the secondary battery may be arranged spaced from each other an interval. The device may further include: a second fixture assembly facing the first fixture assembly with the tray assembly therebetween. On the second fixture assembly, a plurality of second measurement parts including the second measurement part may be located to be spaced from each other at an interval. An advantage of this embodiment may be that a plurality of secondary batteries can be charged or discharged efficiently.

In an embodiment, the secondary battery charging and discharging device may further include: a fourth driver configured to move the first fixture assembly in a width direction of the secondary battery. The device may further include: a fifth driver configured to move the second fixture assembly in a length direction of the secondary battery. The device may further include: a sixth driver configured to move the tray assembly in the length direction of the secondary battery. The device may further include: a controller electrically connected to the fourth driver, the fifth driver, and the sixth driver, and configured to drive the fourth driver, the fifth driver, and the sixth driver. An advantage of this embodiment may be that a plurality of secondary batteries can be charged or discharged even more efficiently.

In an embodiment, the controller may be configured to control at least one of the fourth driver or the fifth driver to adjust a movement distance of the first fixture assembly or the second fixture assembly in correspondence with positions of the secondary batteries. An advantage of this embodiment may be that a plurality of secondary batteries can be charged or discharged automatically.

In an embodiment, the fifth driver may be configured to move the second fixture assembly in the length direction, so that the second terminal of the secondary battery may come into contact with or releases contact with the second current probe. The sixth driver may be configured to move the tray assembly in the length direction, so that the first terminal of the secondary battery comes into contact with or releases contact with the first current probe. An advantage of this embodiment may be that a plurality of secondary batteries can be charged or discharged automatically in a more efficient manner with reduced handling time.

In an embodiment, the temperature probe may be spaced from the secondary battery and/or the receiving volume, while the first current probe may be in contact with the first terminal of the secondary battery. An advantage of this embodiment may be that unintended contact, which may lead to a short circuit, is safely avoided.

According to another aspect of the present disclosure, a secondary battery charging and discharging method may include: preparing a first measurement part. The first measurement part may include: a first base portion; a first current probe joined to the first base portion; and a temperature probe joined to the first base portion. The temperature probe may be spaced from the first current probe at an interval. The method may include: preparing a second measurement part to face the first measurement part with a secondary battery or a receiving volume for receiving the secondary batters therebetween. The second measurement part may include: a second base portion; and a second current probe joined to the second base portion. The method may include: mounting the secondary battery on a tray. The method may include: determining, by a controller, positions of a first terminal and a second terminal of the secondary battery. The method includes: moving, by a driver electrically connected to the controller, at least one of the first measurement part or the second measurement part to within a width of the secondary battery or of the receiving volume in a width direction. The method may include: determining, by the controller, whether or not the positions of the first terminal and the second terminal correspond to positions of the first current probe and the second current probe, respectively. The method may include: moving, by the driver, at least one of the tray or the second measurement part in a length direction of the secondary battery, so that the first current probe and the second current probe come into contact with the first terminal and the second terminal, respectively, in response to determining that the positions of the first terminal and the second terminal correspond to the positions of the first current probe and the second current probe. Hence, due to the providing the two base portions, the first and second current probes can be arranged at different locations, such that different secondary batteries with differently arranged terminals can be charged and/or discharged.

In an embodiment of the method, the preparing of the first measurement part may include arranging the first current probe and the temperature probe within the width of the secondary battery or the receiving volume in the width direction, and the preparing of the second measurement part may include arranging the second current probe within the width of the secondary battery in the width direction.

In an embodiment of the method, the method may further include, after the preparing of the first measurement part, arranging a vacuum hopper or vacuum suction cup within the width of the secondary battery in the width direction to be adjacent to the first measurement part.

In an embodiment of the method, the method may further include, after the determining, by the controller, of whether or not the positions of the first terminal and the second terminal correspond to the positions of the first current probe and the second current probe, respectively, moving, by the driver, at least one of the first measurement part or the second measurement part to within the width of the secondary battery or the receiving volume in the width direction in response to determining that the positions of the first terminal and the second terminal do not correspond to the positions of the first current probe and the second current probe.

In an embodiment of the method, the method may further include, after the preparing of the first measurement part, preparing a third measurement part to be adjacent to the first measurement part, the third measurement part including: a third base portion; and a third current probe joined to the third base portion, and configured to contact the first terminal of the secondary battery.

In an embodiment of the method, the method may be performed by using the secondary battery charging device of the previous aspect of the disclosure.

However, aspects and features of the present disclosure are not limited to those described above, and other aspects and features not mentioned will be clearly understood by a person skilled in the art from the detailed description, described below.

### BRIEF DESCRIPTION OF THE DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings.
FIG. 1 illustrates a charger/discharger applied to a top terminal secondary battery according to a comparative example.
FIG. 2 illustrates a charger/discharger applied to a side terminal secondary battery according to a comparative example.
FIG. 3 illustrates a front view of a secondary battery charging and discharging device according to an embodiment of the present disclosure.
FIG. 4 illustrates a front view of a secondary battery charging and discharging device including a vacuum hopper according to an embodiment of the present disclosure.
FIG. 5 illustrates a front view of a secondary battery charging and discharging device including a third measurement part according to an embodiment of the present disclosure.
FIG. 6 illustrates the secondary battery charging and discharging device of FIG. 5 applied to a top terminal secondary battery according to an embodiment of the present disclosure.
FIG. 7 illustrates a movement of a first measurement part and a second measurement part in correspondence with a position of a secondary battery in a secondary battery charging and discharging device according to an embodiment of the present disclosure.
FIG. 8 illustrates a movement of the first measurement part and the second measurement part of FIG. 7 in correspondence with the position of the secondary battery in the secondary battery charging and discharging device according to an embodiment of the present disclosure.
FIG. 9 illustrates a first fixture assembly, a second fixture assembly, and a tray assembly of a secondary battery charging and discharging device according to an embodiment of the present disclosure.
FIG. 10 illustrates a flowchart of a secondary battery charging and discharging method according to an embodiment of the present disclosure.

### DETAILED DESCRIPTION

Hereinafter, embodiments of the present disclosure will be described, in detail, with reference to the accompanying drawings. The terms or words used in the present specification and claims are not to be limitedly interpreted as general or dictionary meanings and should be interpreted as meanings and concepts that are consistent with the technical idea of the present disclosure on the basis of the principle that an inventor can be his/her own lexicographer to appropriately define concepts of terms to describe his/her invention in the best way.

The embodiments described in this specification and the configurations shown in the drawings are only some of the embodiments of the present disclosure and do not represent all of the technical aspects, and features of the present disclosure. Accordingly, it should be understood that there may be various modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein. All such ranges are intended to be inherently described in this specification such that amending to expressly recite any such subranges would comply with the requirements of 35 U.S.C. § 112(a) and 35 U.S.C. § 132(a).

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

Arranging an arbitrary element "above (or below)" or "on (under)" another element may mean that the arbitrary element may be disposed in contact with the upper (or lower) surface of the element, and another element may also be interposed between the element and the arbitrary element disposed on (or under) the element.

In addition, it will be understood that when a component is referred to as being "linked," "coupled," or "connected" to another component, the elements may be directly "coupled," "linked" or "connected" to each other, or another component may be "interposed" between the components".

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

The terms used in the present specification are for describing embodiments of the present disclosure and are not intended to limit the present disclosure.

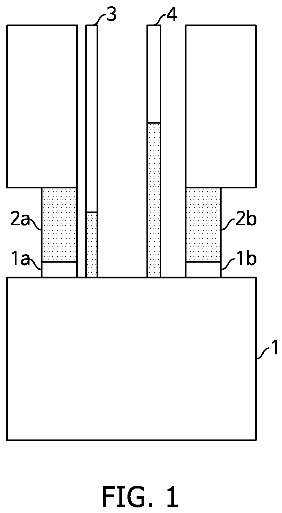

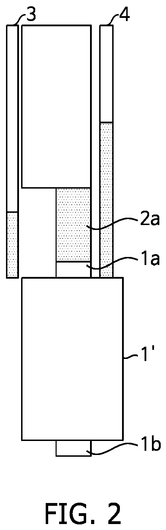

FIG. 1 illustrates a charger/discharger applied to a top terminal secondary battery according to a comparative example. FIG. 2 illustrates a charger/discharger applied to a side terminal secondary battery according to a comparative example.

A secondary battery charger/discharger may be used to test secondary batteries. In a case where heat generated from the secondary battery is not controlled, excessive heat may be generated in a current probe of the secondary battery charger/discharger and the secondary battery, and thus, physical damage may be caused to the current probe and a secondary battery tap (e.g., a secondary battery terminal). To avoid a possibility of the damage that may be caused, the secondary battery charger/discharger may be provided with a temperature probe. As illustrated in FIGS. 1 and 2, in a case where current probes 2a and 2b and a temperature probe 3 are provided separately, some of the following may occur.

As illustrated in FIG. 1, a top terminal secondary battery 1 has a positive terminal 1a and a negative terminal 1b of the secondary battery positioned on one long side. Because a terminal spacing of the top terminal secondary battery 1 may be wide, there may be fewer restrictions on a width-wise movement of the current probes 2a and 2b, the temperature probe 3, and a vacuum hopper 4 in the secondary battery. In other words, because the current probes 2a and 2b, the temperature probe 3, and the vacuum hopper 4 may be positioned in the inside of the top terminal secondary battery 1 in a width direction, charging and discharging may not be sufficiently performed.

On the other hand, as illustrated in FIG. 2, a side terminal secondary battery 1' has a terminal block of a positive terminal 1a and a negative terminal 1b positioned on a short side of the secondary battery. The current probes 2a and 2b, the temperature probe 3, and the vacuum hopper 4 restrict the width-wise movement of the secondary battery. In other words, because the current probes 2a and 2b, the temperature probe 3, and the vacuum hopper 4 may not be positioned in the inside of the side terminal secondary battery 1' in a width direction, charging and discharging may not be sufficiently performed. For example, in a case where the temperature probe 3 is positioned on the outside of the secondary battery in the width direction, the temperature of the secondary battery 1 may not be accurately measured.

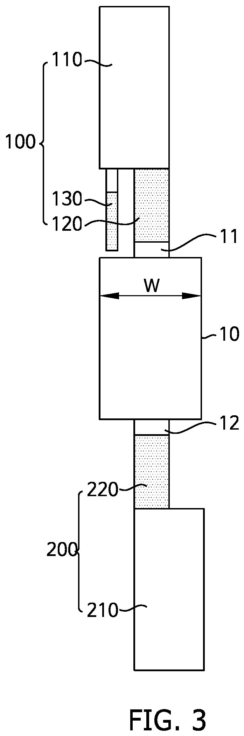

FIG. 3 illustrates a front view of a secondary battery charging and discharging device according to an embodiment of the present disclosure. Referring to FIG. 3, the secondary battery charging and discharging device according to an embodiment of the present disclosure may include a first measurement part 100, and a second measurement part 200 positioned to face the first measurement part 100 with a secondary battery (e.g., a battery cell) 10 therebetween.

According to an embodiment, the secondary battery 10 may be a side terminal secondary battery having a positive terminal and a negative terminal positioned at opposite sides from each other. The side terminal secondary battery may include an electrode assembly, a sub-tab, a current collector, a rivet, a terminal plate, and the like. The side terminal secondary battery has relatively less dead space when compared to that of the top terminal secondary battery in which both the positive terminal and the negative terminal are positioned at an upper end. The side terminal secondary battery may have a relatively higher energy density than that of the top terminal secondary battery, because more capacity may be packed inside a can thereof.

In an embodiment, the first measurement part 100 may include a first base portion 110, a first current probe 120, and a temperature probe 130. In the first base portion 110, the first current probe 120 and the temperature probe 130 may be arranged to be spaced apart from each other at a suitable interval (e.g., a preset or predetermined interval). The first current probe 120 may be connected to (e.g., joined to or attached to) the first base portion 110, and may be in contact with a first terminal 11 of the secondary battery 10. The first current probe 120 may be connected to (e.g., joined to or attached to) the first base portion 110 by a laser welding or an ultrasonic welding. The first terminal 11 of the secondary battery 10 may serve as the positive terminal. The first current probe 120 may perform charging and discharging of the secondary battery 10 by selectively supplying a current and a voltage while in contact with the first terminal 11.

In an embodiment, the temperature probe 130 may be connected to (e.g., joined to or attached to) the first base portion 110, and may be arranged to be spaced apart from the first current probe 120 at a suitable interval (e.g., a preset or predetermined interval). The interval may be determined (e.g., may be set) in consideration of a size of the secondary battery 10 in the width direction, and the interval is not limited to particular numerical terms. The temperature probe 130 may measure the temperature of the secondary battery 10 in a case where charging and discharging are performed.

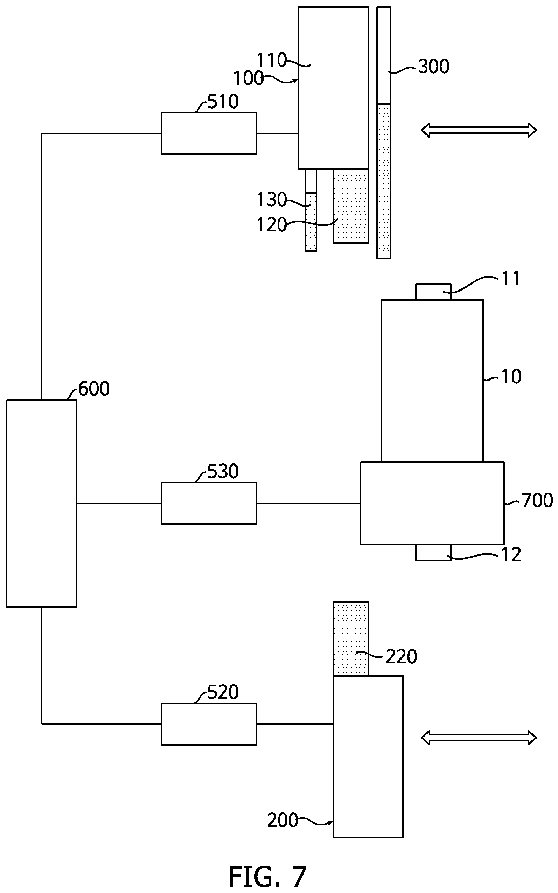

In more detail, the temperature probe 130 may be arranged to be spaced apart from the secondary battery 10, while the first current probe 120 is in contact with the first terminal 11 of the secondary battery 10. For example, the temperature probe 130 may be a kind of temperature sensor that is connected to a controller 600 (e.g., see FIGS. 7 to 9). In more detail, as illustrated in FIG. 3, the temperature probe 130 may be positioned in the inside of the secondary battery 10 in the width direction (e.g., in a plan view), with one end adjacent to the short side of the secondary battery 10, and may measure the temperature of the secondary battery 10 while performing charging and discharging.

In an embodiment, the second measurement part 200 may be positioned to face the first measurement part 100 with the secondary battery 10 therebetween, and may include a second base portion 210 and a second current probe 220. The second current probe 220 may be connected to (e.g., joined to or attached to) the second base portion 210, and may be in contact with a second terminal 12 of the secondary battery 10. The second current probe 220 may be connected to (e.g., joined to or attached to) the second base portion 210 by a laser welding or an ultrasonic welding. The second terminal 12 of the secondary battery 10 may serve as the negative terminal. The second current probe 220 may perform charging and discharging of the secondary battery 10 by selectively supplying a current and a voltage while in contact with the second terminal 12.

In another embodiment, the second measurement part 200 may further include a temperature probe 130. In this case, the temperature probe 130 may be connected to (e.g., joined to or attached to) the second base portion 210, and may be arranged to be spaced apart from the second current probe 220 at a suitable interval (e.g., a preset or predetermined interval). The interval may be determined (e.g., may be set) in consideration of a size of the secondary battery 10 in the width direction, and the interval is not limited to particular numerical terms.

The first current probe 120 and the second current probe 220 may charge the secondary battery 10. The first current probe 120 and the second current probe 220 may be in contact with the first terminal 11 or the second terminal 12, so as to charge and discharge the secondary battery 10. The temperature probe 130 may measure the temperature of a secondary battery body, a secondary battery tab, or the first current probe 120 and/or the second current probe 220 during charging and discharging of the secondary battery 10, and may maintain or substantially maintain the temperature within a desired temperature range (e.g., a preset or predetermined temperature range). For example, the temperature range may be 25°C to 30°C.

The first current probe 120, the second current probe 220, and the temperature probe 130 may be arranged in the inside of the secondary battery 10 in the width (W) direction (e.g., the left-right direction in FIG. 3). In other words, in a front view, the first current probe 120, the second current probe 220, and the temperature probe 130 may be arranged within a width of a relevant side of the secondary battery 10 in the width (W) direction. In more detail, the first current probe 120 and the temperature probe 130 connected to (e.g., joined to or attached to) the first base portion 110 may be arranged in the inside (e.g., within a width) of the secondary battery 10 in the width (W) direction. The second current probe 220 connected to (e.g., joined to or attached to) the second base portion 210 may be arranged in the inside of the secondary battery 10 in the width (W) direction. In another embodiment of the second measurement part 200 that further includes the temperature probe 130, the second current probe 220 and the temperature probe 130 connected to (e.g., joined to or attached to) the second base portion 210 may be arranged in the inside of the secondary battery 10 in the width (W) direction.

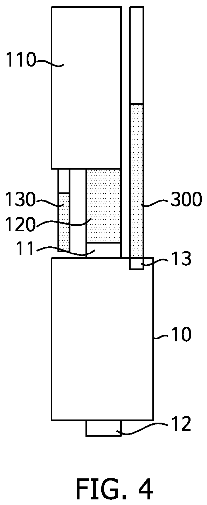

FIG. 4 illustrates a front view of a secondary battery charging and discharging device including a vacuum hopper according to an embodiment of the present disclosure.

Referring to FIG. 4, the secondary battery charging and discharging device according to an embodiment of the present disclosure may further include a vacuum hopper 300. In an embodiment, the vacuum hopper 300 may be positioned adjacent to the first measurement part 100, and arranged in the inside (e.g., within a width) of a secondary battery 10 in the width direction. The vacuum hopper 300 may be in contact with a hole 13 of the secondary battery 10 formed adjacent to the first terminal 11, while the first current probe 120 is in contact with the first terminal 11.

In more detail, the vacuum hopper 300 may be in contact with the hole 13 of the secondary battery 10 so as to remove gas from the secondary battery 10. For example, the vacuum hopper 300 may discharge gas emitted from the electrode assembly of the secondary battery 10 to the outside. As another example, the vacuum hopper 300 may suck in an electrolyte of the secondary battery 10 and gas contained in the electrolyte, may discharge the gas contained in the electrolyte to the outside, and may store the electrolyte in a vacuum nozzle of the vacuum hopper 300 and then inject the electrolyte into the inside of the secondary battery 10. Due to the vacuum hopper 300, defects of the secondary battery 10 may be reduced, and a lifespan of the secondary battery 10 may be increased.

In an embodiment, as illustrated in FIG. 4, the hole 13 of the secondary battery 10 may be formed on the short side adjacent to the first terminal 11. The vacuum hopper 300 may be in contact with the hole 13, and may remove gas generated inside the secondary battery 10 during charging and discharging. The vacuum hopper 300 may be arranged to be spaced apart from the first measurement part 100 at a suitable interval (e.g., a preset or predetermined interval), and the replacement cycle may be determined (e.g., may be set) differently from that of the first measurement part 100.

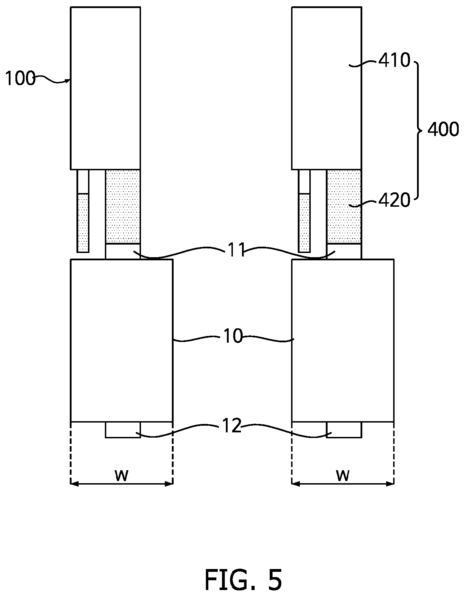

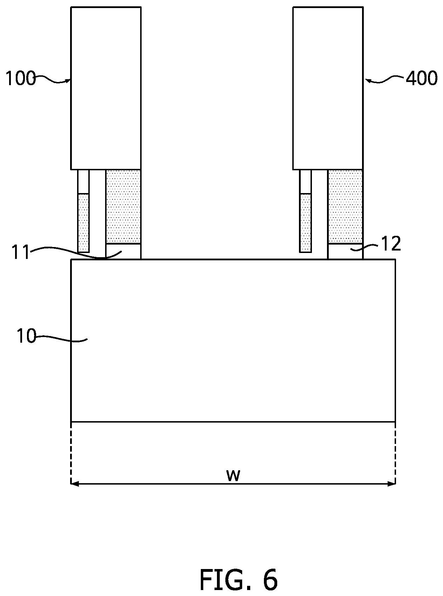

FIG. 5 illustrates a front view of a secondary battery charging and discharging device including a third measurement part according to an embodiment of the present disclosure. FIG. 6 illustrates the secondary battery charging and discharging device of FIG. 5 applied to a top terminal secondary battery according to an embodiment of the present disclosure.

Referring to FIGS. 5 and 6, the secondary battery charging and discharging device according to an embodiment of the present disclosure may further include a third measurement part 400 arranged adjacent to the first measurement part 100. In an embodiment, the third measurement part 400 may include a third base portion 410 and a third current probe 420. The third current probe 420 may be connected to (e.g., joined to or attached to) the third base portion 410, and may be in contact with the first terminal 11 of a secondary battery 10. The third current probe 420 may be arranged in the inside (e.g., within a width) of the secondary battery 10 in the width (W) direction in a state of being connected to (e.g., joined to or attached to) the third base portion 410.

The first measurement part 100 and the third measurement part 400 may be arranged to be spaced apart from each other at a suitable interval (e.g., a preset or predetermined interval). In an embodiment, a distance between the first measurement part 100 and the third measurement part 400 may be determined (e.g., may be set) according to a spacing between the side terminal secondary batteries 10, as illustrated in FIG. 5.

In another embodiment, a distance between the first measurement part 100 and the third measurement part 400 may be determined (e.g., may be set) according to a spacing between the first terminal 11 and the second terminal 12 of the top terminal secondary battery 10, as illustrated in FIG. 6. Therefore, the secondary battery charging and discharging device according to some embodiments of the present disclosure may be used for a plurality of different models of secondary batteries 10 having different shapes and/or sizes from each other.

In more detail, referring to FIG. 5, in a case where charging and discharging of the secondary battery 10 are performed, the first measurement part 100 and the third measurement part 400 may contact a plurality of first terminals 11. A plurality of the second measurement parts 200 may respectively contact the second terminals 12. In this case, a first current probe 120 and a temperature probe 130 of the first measurement part 100 may be arranged in the inside (e.g., within a width) of the secondary battery 10 in the width (W) direction, and the third current probe 420 of the third measurement part 400 may be arranged in the inside (e.g., within a width) of the secondary battery 10 in the width (W) direction.

In an embodiment, the third measurement part 400 may further include the temperature probe 130. In this case, the third current probe 420 and the temperature probe 130 of the third measurement part 400 may be arranged in the inside (e.g., within a width) of the secondary battery 10 in the width (W) direction.

In the case of the top terminal secondary battery 10, referring to FIG. 6, in a case of charging and discharging the secondary battery 10, the third measurement part 400 may be in contact with the second terminal 12 while the first measurement part 100 is in contact with the first terminal 11. In this case, the first current probe 120 and the temperature probe 130 of the first measurement part 100 and the third current probe 420 of the third measurement part 400 may be arranged in the inside (e.g., within a width) of the secondary battery 10 in the width (W) direction.

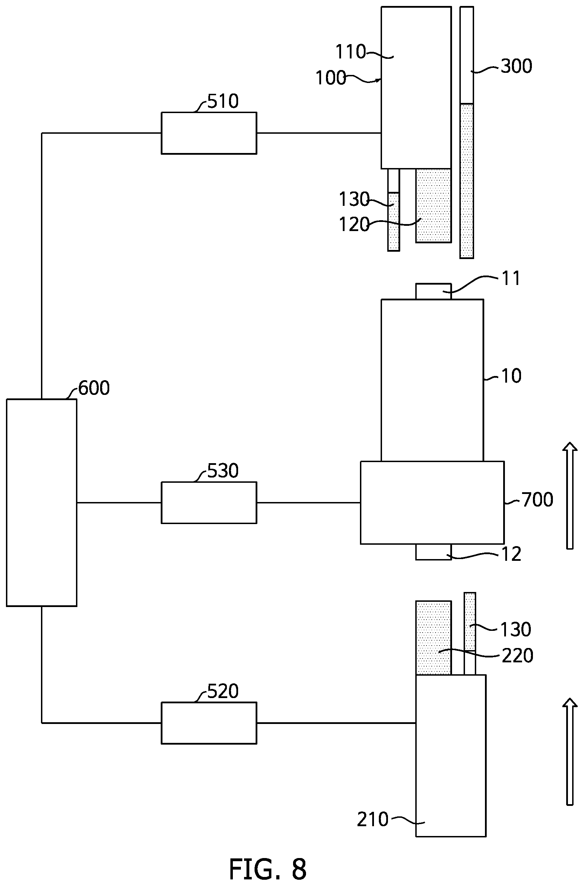

FIG. 7 illustrates a movement of a first measurement part and a second measurement part in correspondence with a position of a secondary battery in a secondary battery charging and discharging device according to an embodiment of the present disclosure. FIG. 8 illustrates a movement of the first measurement part and the second measurement part of FIG. 7 in correspondence with the position of the secondary battery in the secondary battery charging and discharging device according to an embodiment of the present disclosure.

The secondary battery charging and discharging device according to an embodiment of the present disclosure may further include a tray 700, which has an open upper portion to form an accommodation space therein, and on which a secondary battery 10 is mounted in the accommodation space. In an embodiment, the tray 700 may be a rectangular box-shaped structure having the open upper portion to form the accommodation space therein. The accommodation space of the tray 700 may be partitioned by a plurality of partitions formed in the horizontal or vertical direction. The width of one section of the partitioned accommodation space of the tray 700 may be formed to correspond to the width of the secondary battery 10, so that a plurality of secondary batteries 10 may be mounted in the sections, respectively, while being spaced apart from each other. The secondary battery 10 may be fixed in position in the state of being mounted on the tray 700, and may be prevented or substantially prevented from moving even in a case where an external force is applied to the tray 700.

The tray 700 may have an opening formed at the lower portion thereof, so that the second terminal 12 of the secondary battery 10 may be exposed to the outside of the tray 700. The tray 700 may have any suitable structure that supports the secondary battery 10 vertically, and that allows the second terminal 12 to protrude downward.

The secondary battery charging and discharging device according to an embodiment of the present disclosure may further include a first driver 510, a second driver 520, and a controller 600. The first driver 510 may be connected to the first measurement part 100 to move the first measurement part 100. The second driver 520 may be connected to the second measurement part 200 to move the second measurement part 200. For example, the first driver 510 and the second driver 520 may include (e.g., may be) actuators, such as pneumatic cylinders, but the present disclosure is not limited thereto, as long as the first driver 510 and the second driver 520 have a suitable configuration capable of moving the first measurement part 100 and the second measurement part 200. The controller 600 may be electrically connected to the first driver 510 and the second driver 520 to drive the first driver 510 and the second driver 520.

In an embodiment, the controller 600 may control the first driver 510 or the second driver 520 to adjust a movement distance of the first measurement part 100 or the second measurement part 200 according to the position of the secondary battery 10. In more detail, the first driver 510 may move the first measurement part 100 in the width direction of the secondary battery 10, so that the first current probe 120 comes into contact with or releases contact with the first terminal 11 of the secondary battery 10. In addition, the second driver 520 may move the second measurement part 200 in the length direction of the secondary battery 10, so that the second terminal 12 of the secondary battery 10 comes into contact with or releases contact with the second current probe 220.

As illustrated in FIG. 7, the first driver 510 may move the first measurement part 100 in the width direction of the secondary battery 10, so that the position of the first current probe 120 corresponds to the position of the first terminal 11 of the secondary battery 10. Similarly, the second driver 520 may move the second measurement part 200 in the width direction of the secondary battery 10, so that the position of the second current probe 220 corresponds to the position of the second terminal 12 of the secondary battery 10.

In an embodiment, the secondary battery charging and discharging device may further include a third driver 530 connected to the tray 700. The third driver 530 may be connected to the tray 700 to move the tray 700 in the length direction of the secondary battery 10. The third driver 530 may move the tray 700, so that the first terminal 11 of the secondary battery 10 comes into contact with or release contact with the first current probe 120.

In FIG. 7, in a case where the first driver 510 moves the first measurement part 100 so that the position of the first current probe 120 corresponds to the position of the first terminal 11, and the second driver 520 moves the second measurement part 200 so that the position of the second current probe 220 corresponds to the position of the second terminal 12, the state illustrated in FIG. 8 may be obtained.

As illustrated in FIG. 8, the position of the first current probe 120 may correspond to the position of the first terminal 11, and the position of the second current probe 220 may correspond to the position of the second terminal 12. In this case, the second driver 520 may move the second measurement part 200 in the length direction of the secondary battery 10, so that the second terminal 12 comes into contact with or releases contact with the second current probe 220. In addition, the third driver 530 may move the tray 700 in the length direction of the secondary battery 10, so that the first terminal 11 of the secondary battery 10 comes into contact with or releases contact with the first current probe 120.

In an embodiment, the secondary battery charging and discharging device according to an embodiment of the present disclosure may be configured such that the third driver 530 raises the tray 700 so that the first terminal 11 of the secondary battery 10 comes into contact with the first current probe 120, and then the second driver 520 raises the second measurement part 200 so that the second terminal 12 comes into contact with the second current probe 220. As another example, in another embodiment, the second driver 520 and the third driver 530 may be configured to operate so that the tray 700 and the second measurement part 200 move upward together, while the second terminal 12 is in contact with the second current probe 220, and the first terminal 11 of the secondary battery 10 comes into contact with the first current probe 120.

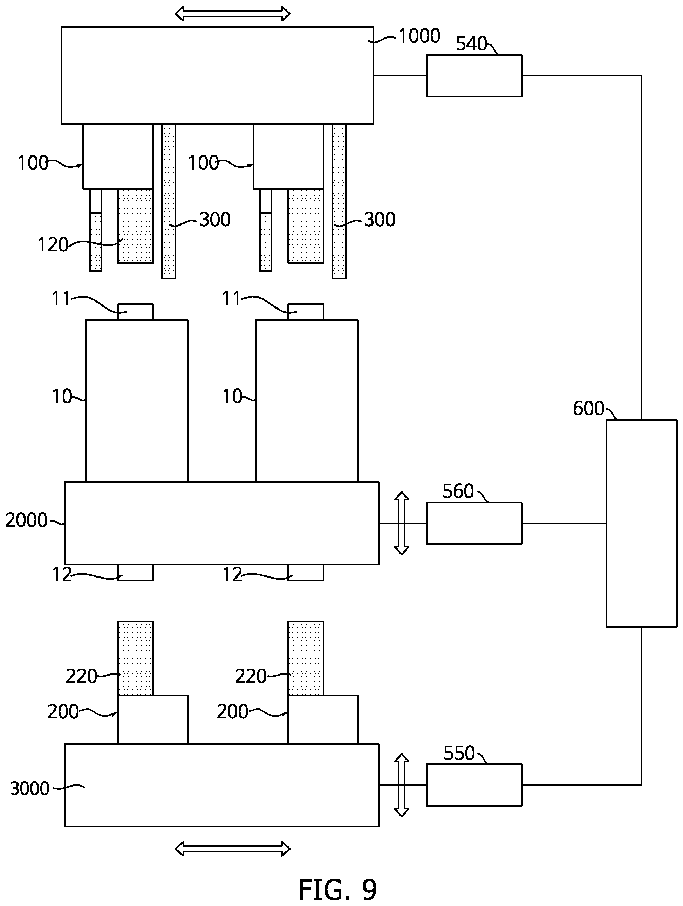

FIG. 9 illustrates a first fixture assembly, a second fixture assembly, and a tray assembly of a secondary battery charging and discharging device according to an embodiment of the present disclosure.

Referring to FIG. 9, the secondary battery charging and discharging device of an embodiment of the present disclosure may include a first fixture assembly 1000 including a plurality of first measurement parts 100, a second fixture assembly 3000 including a plurality of second measurement parts 200, and a tray assembly 2000. In an embodiment, the first fixture assembly 1000 may be arranged, so that the first measurement parts 100 are spaced apart from each other at a suitable interval (e.g., a certain or predetermined interval). For example, the first fixture assembly 1000 may have a mounting plate forming a lower portion of a rectangular frame, so that the first measurement parts 100 may be arranged to be spaced apart from each other at a suitable interval (e.g., a certain or predetermined interval).

In an embodiment, the tray assembly 2000 may have a box shape with an open upper portion, and a plurality of secondary batteries 10 may be mounted to be spaced apart from each other at a suitable interval (e.g., a certain or predetermined interval). The tray assembly 2000 may have an opening formed at the lower portion thereof, so that the second terminals 12 of the secondary batteries 10 may be exposed to the outside. The tray assembly 2000 may have any suitable structure that supports the secondary batteries 10 vertically, and that allows the second terminals 12 to protrude downward.

In an embodiment, the second fixture assembly 3000 may be arranged so that the second measurement parts 200 are spaced apart from each other at a suitable interval (e.g., a certain or predetermined interval). For example, the second fixture assembly 3000 may have a mounting plate forming a lower portion of a rectangular frame, so that the second measurement parts 200 may be arranged to be spaced apart from each other at a suitable interval (e.g., a certain or predetermined interval). The second fixture assembly 3000 may be positioned to face the first fixture assembly 1000 with the tray assembly 2000 therebetween.

In an embodiment, the secondary battery charging and discharging device may further include a fourth driver 540 for moving the first fixture assembly 1000, a fifth driver 550 for moving the second fixture assembly 3000, and a sixth driver 560 for moving the tray assembly 2000. The controller 600 may be electrically connected to the fourth driver 540, the fifth driver 550, and the sixth driver 560, and may drive the fourth driver 540, the fifth driver 550, and the sixth driver 560.

In more detail, the fourth driver 540 may move the first fixture assembly 1000 in the width direction of the secondary battery 10. The fifth driver 550 may move the second fixture assembly 3000 in the width direction or the length direction of the secondary battery 10. The sixth driver 560 may move the tray assembly 2000 in the length direction of the secondary battery 10.

In an embodiment, the controller 600 may control the fourth driver 540 or the fifth driver 550 to adjust a movement distance of the first fixture assembly 1000 or the second fixture assembly 3000 according to the positions of the secondary batteries 10. In more detail, the controller 600 may control the fourth driver 540 or the fifth driver 550 according to the positions of the first terminal 11 and the second terminal 12 of the secondary batteries 10 mounted on the tray assembly 2000.

As illustrated in FIG. 9, in a case where the positions of the first terminals 11 of the secondary batteries 10 correspond to the positions of the first current probes 120, and in a case where the positions of the second terminals 12 correspond to the positions of the second current probes 220, the fifth driver 550 and the sixth driver 560 may be operated.

In an embodiment, the fifth driver 550 may move the second fixture assembly 3000 in the length direction of the secondary battery 10, so that the second terminal 12 of the secondary battery 10 comes into contact with or releases contact with the second current probe 220. The sixth driver 560 may move the tray assembly 2000 in the length direction of the secondary battery 10, so that the first terminal 11 of the secondary battery 10 comes into contact with or releases contact with the first current probe 120.

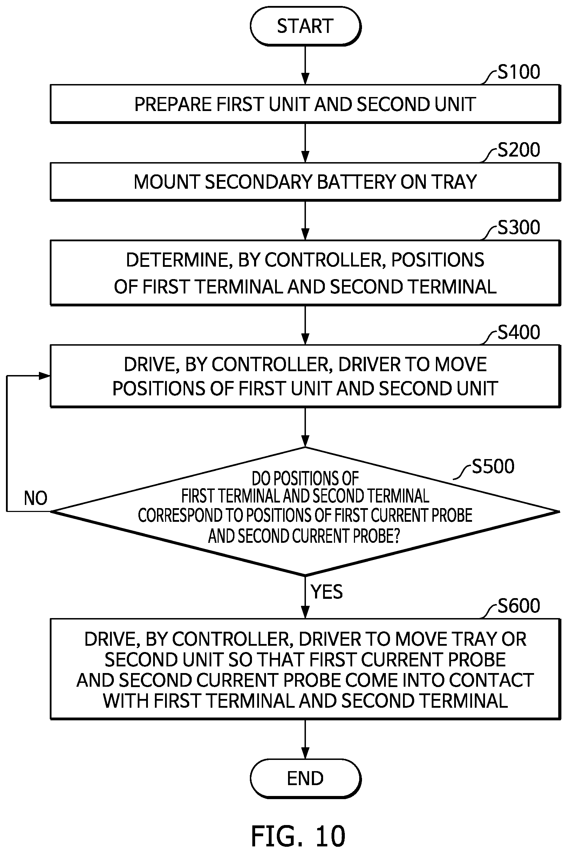

FIG. 10 illustrates a flowchart of a secondary battery charging and discharging method according to an embodiment of the present disclosure.

Referring to FIG. 10, the secondary battery charging and discharging method according to an embodiment of the present disclosure may include preparing the first measurement part 100 and the second measurement part 200 (S100), mounting the secondary battery 10 on the tray 700 (S200), determining, by the controller 600, the positions of the first terminal 11 and the second terminal 12 of the secondary battery 10 (S300), driving, by the controller 600, the driver to move the positions of the first measurement part 100 and the second measurement part 200 (S400), determining, by the controller 600, whether or not the positions of the first terminal 11 and the second terminal 12 correspond to the positions of the first current probe 120 and the second current probe 220 (S500), and driving, by the controller 600, the driver to move at least one of the tray 700 or the second measurement part 200 so that first current probe and second current probe come into contact with the first terminal and the second terminal (S600).

The preparing of the first measurement part 100 and the second measurement part 200 (S100) may include preparing the first measurement part including the first base portion 110, the first current probe 120 connected to (e.g., joined to or attached to) the first base portion 110, and the temperature probe 130 connected to (e.g., joined to or attached to) the first base portion 110 and arranged spaced apart from the first current probe 120 at a suitable interval (e.g., a preset or predetermined interval). In addition, the preparing of the first measurement part 100 and the second measurement part 200 (S100) may include preparing the second measurement part 200 positioned to face the first measurement part 100 with the secondary battery 10 therebetween, and including the second base portion 210 and the second current probe 220 connected to (e.g., joined to or attached to) the second base portion 210.

The preparing of the first measurement part 100 may include arranging the first current probe 120 and the temperature probe 130 in the inside of (e.g., within a width of) the secondary battery 10 in the width direction. The preparing of the second measurement part 200 may include arranging the second current probe 220 in the inside of (e.g., within a width of) the secondary battery 10 in the width direction. The secondary battery charging and discharging method may further include, after the preparing of the first measurement part 100, arranging the vacuum hopper 300 in the inside of (e.g., within a width of) the secondary battery 10 in the width direction, so as to be adjacent to the first measurement part 100.

The secondary battery charging and discharging method may further include, after the preparing of the first measurement part, preparing the third measurement part 400 positioned adjacent to the first measurement part 100, and including the third base portion 410 and the third current probe 420 connected to (e.g., joined to or attached to) the third base portion 410, and coming into contact with the first terminal 11 of the secondary battery 10.

The secondary battery charging and discharging method may further include, after the determining, by the controller 600, of the positions of the first terminal 11 and the second terminal 12 of the secondary battery 10, driving, by the controller 600, the driver to move the positions of the first measurement part 100 and the second measurement part 200 (S400). In more detail, the driving, by the controller 600, the driver to move the positions of the first measurement part 100 and the second measurement part 200 (S400) may include moving, by the driver electrically connected to the controller 600, at least one of the first measurement part 100 or the second measurement part 200 to the inside of (e.g., within a width of) the secondary battery 10 in the width direction.

The determining, by the controller 600, whether or not the positions of the first terminal 11 and the second terminal 12 correspond to the positions of the first current probe 120 and the second current probe 220 may include moving, by the driver, at least one of the tray 700 or the second measurement part 200 in the length direction of the secondary battery 10, so that the first current probe 120 and the second current probe 220 come into contact with the first terminal 11 and the second terminal 12, respectively, in response to determining that the positions of the first terminal 11 and the second terminal 12 correspond to the positions of the first current probe 120 and the second current probe 220.

The secondary battery charging and discharging method may further include, after the determining, by the controller 600, of whether or not the positions of the first terminal 11 and the second terminal 12 correspond to the positions of the first current probe 120 and the second current probe 220, moving, by the driver, at least one of the first measurement part 100 or the second measurement part 200 to the inside of (e.g., within the width of) the secondary battery 10 in the width direction in response to determining that the positions of the first terminal 11 and the second terminal 12 do not correspond to the positions of the first current probe 120 and the second current probe 220.

The electronic or electric devices and/or any other relevant devices or components according to embodiments of the present disclosure described herein (e.g., the controller) may be implemented utilizing any suitable hardware, firmware (e.g. an application-specific integrated circuit), software, or a combination of software, firmware, and hardware. For example, the various components of these devices may be formed on one integrated circuit (IC) chip or on separate IC chips. Further, the various components of these devices may be implemented on a flexible printed circuit film, a tape carrier package (TCP), a printed circuit board (PCB), or formed on one substrate. Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the example embodiments of the present disclosure.

Although the present disclosure has been described with reference to embodiments and drawings illustrating aspects thereof, the present disclosure is not limited thereto. Various modifications and variations can be made by a person skilled in the art to which the present disclosure belongs within the scope of the present disclosure and the claims, below.

## Claims

1. A secondary battery charging and discharging device comprising:
a first measurement part (100) comprising:
a first base portion (110);
a first current probe (120) joined to the first base portion (110), and configured to contact a first terminal (11) of a secondary battery (10); and
a temperature probe (130) joined to the first base portion (110), spaced from the first current probe (120) at an interval, and configured to measure a temperature of the secondary battery (10); and
a second measurement part (200) facing the first measurement part (100) with the secondary battery (10) therebetween, and comprising:
a second base portion (210); and
a second current probe (220) joined to the second base portion (210), and configured to contact a second terminal (12) of the secondary battery (10),
wherein the first current probe (120) and the second current probe (220) are configured to charge or discharge the secondary battery (10).

2. The secondary battery charging and discharging device as claimed in claim 1, wherein the first current probe (120), the second current probe (220), and the temperature probe (130) are located within a width of the secondary battery (10) in a width direction.

3. The secondary battery charging and discharging device as claimed in claim 1 or 2, further comprising a vacuum hopper (300) adjacent to the first measurement part (100), and located with a width of the secondary battery (10) a width direction.

4. The secondary battery charging and discharging device as claimed in claim 3, wherein the vacuum hopper (300) is configured to contact a hole (13) of the secondary battery (10) adjacent to the first terminal (11), while the first current probe (120) is in contact with the first terminal (11).

5. The secondary battery charging and discharging device as claimed in any of claims 1 to 4, further comprising a third measurement part (400) adjacent to the first measurement part (100), and comprising:
a third base portion (410); and
a third current probe (420) joined to the third base portion (410), and configured to contact the first terminal (11) of the secondary battery (10) or the second terminal (12) of the secondary battery (10),
wherein the third current probe (420) is located with a width of the secondary battery (10) in a width direction.

6. The secondary battery charging and discharging device as claimed in any of claims 1 to 5, further comprising:
a first driver (510) connected to the first measurement part (100), and configured to move the first measurement part (100);
a second driver (520) connected to the second measurement part (200), and configured to move the second measurement part (200); and
a controller (600) electrically connected to the first driver (510) and the second driver (520), and configured to drive the first driver (510) and the second driver (520).

7. The secondary battery charging and discharging device as claimed in claim 6, wherein the controller (600) is configured to control at least one of the first driver (510) and the second driver (520) to adjust a movement distance of the first measurement part (100) and/or the second measurement part (200) in correspondence with a position of the secondary battery (10).

8. The secondary battery charging and discharging device as claimed in claim 6 or 7, wherein the first driver (510) is configured to move the first measurement part (100) in a width direction of the secondary battery (10), so that the first current probe (120) comes into contact with or releases contact with the first terminal (11) of the secondary battery (10), and
wherein the second driver (520) is configured to move the second measurement part (200) in a length direction of the secondary battery (10), so that the second current probe (220) comes into contact with or releases contact with the second terminal (12) of the secondary battery (10).

9. The secondary battery charging and discharging device as claimed in and of claims 6 to 8, further comprising a tray (700) having an open upper portion and an accommodation space therein, and configured to receive the secondary battery (10) in the accommodation space.

10. The secondary battery charging and discharging device as claimed in claim 9, further comprising a third driver (530) connected to the tray (700), and configured to move the tray (700) in a length direction of the secondary battery (10), so that the first terminal (11) of the secondary battery (10) comes into contact with or releases contact with the first current probe (120).

11. The secondary battery charging and discharging device as claimed in any of claims 1 to 5, further comprising:
a first fixture assembly (1000) on which a plurality of first measurement parts (100) including the first measurement part (100) are located at intervals;
a tray assembly (2000) having a box shape with an open upper portion, and in which a plurality of secondary batteries including the secondary battery (10) are spaced from each other at an interval; and
a second fixture assembly (3000) facing the first fixture assembly (1000) with the tray assembly (2000) therebetween, and on which a plurality of second measurement parts (200) including the second measurement part (200) are located to be spaced from each other at an interval.

12. The secondary battery charging and discharging device as claimed in claim 11, further comprising:
a fourth driver (540) configured to move the first fixture assembly (1000) in a width direction of the secondary battery (10);
a fifth driver (550) configured to move the second fixture assembly (3000) in a length direction of the secondary battery (10);
a sixth driver (560) configured to move the tray assembly (2000) in the length direction of the secondary battery (10); and
a controller (600) electrically connected to the fourth driver (540), the fifth driver (550), and the sixth driver (560), and configured to drive the fourth driver (540), the fifth driver (550), and the sixth driver (560).

13. The secondary battery charging and discharging device as claimed in claim 12, wherein the controller (600) is configured to control at least one of the fourth driver (540) or the fifth driver (550) to adjust a movement distance of the first fixture assembly (1000) or the second fixture assembly (3000) in correspondence with positions of the secondary batteries.

14. The secondary battery charging and discharging device as claimed in claim 12 or 13, wherein the fifth driver (550) is configured to move the second fixture assembly (3000) in the length direction of the secondary battery (10), so that the second terminal (12) of the secondary battery (10) comes into contact with or releases contact with the second current probe (220), and
wherein the sixth driver (560) is configured to move the tray assembly (2000) in the length direction of the secondary battery (10), so that the first terminal (11) of the secondary battery (10) comes into contact with or releases contact with the first current probe (120).
